(19) Europäisches Patentamt / European Patent Office / Office européen des brevets

(11) **EP 3 067 704 B1**

(12) **FASCICULE DE BREVET EUROPEEN**

(45) Date de publication et mention de la délivrance du brevet:
**19.07.2017 Bulletin 2017/29**

(51) Int Cl.:
*G01R 29/08* (2006.01)          *G01V 3/08* (2006.01)
*G01R 35/00* (2006.01)          *G01R 29/12* (2006.01)

(21) Numéro de dépôt: **16155468.8**

(22) Date de dépôt: **12.02.2016**

(54) **DISPOSITIF DE MESURE D'UN CHAMP ÉLECTRIQUE EN MILIEU CONDUCTEUR ET PROCÉDÉ DE CALIBRATION DE CE DISPOSITIF**

VORRICHTUNG ZUM MESSEN EINES ELEKTRISCHEN FELDS IN EINEM LEITENDEN MEDIUM, UND KALIBRIERVERFAHREN DIESER VORRICHTUNG

DEVICE FOR MEASURING AN ELECTRIC FIELD IN A CONDUCTIVE MEDIUM AND METHOD FOR CALIBRATING SAID DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.02.2015 FR 1551297**

(43) Date de publication de la demande:
**14.09.2016 Bulletin 2016/37**

(73) Titulaire: **COMMISSARIAT À L'ÉNERGIE ATOMIQUE ET AUX ÉNERGIES ALTERNATIVES**
**75015 Paris (FR)**

(72) Inventeurs:
• **BAICRY, Mathieu**
  **38360 SASSENAGE (FR)**
• **LE PRADO, Matthieu**
  **38160 SAINT-MARCELLIN (FR)**

(74) Mandataire: **Thibon, Laurent**
  **Cabinet Beaumont**
  **1, rue Champollion**
  **38000 Grenoble (FR)**

(56) Documents cités:
WO-A2-2008/121796      US-A- 3 641 427
US-A1- 2012 161 774

**Description**

Domaine

La présente demande concerne un dispositif pour la mesure d'un champ électrique en milieu conducteur. Elle s'applique en particulier à des mesures de champ électrique sous-marines.

Exposé de l'art antérieur

On a déjà proposé un dispositif de mesure d'un champ électrique en mer, ou électromètre marin, comportant deux électrodes immergées éloignées d'une distance l, reliées à un dispositif de mesure de tension. Pour mesurer un champ électrique E dans la zone située entre les deux électrodes, on mesure la tension U entre les électrodes. Le champ E se déduit de cette mesure par la formule E = U/l. Les électromètres de ce type sont dits "à mesure de tension".

Un inconvénient des électromètres à mesure de tension est que du fait de l'impédance relativement élevée du dispositif de mesure de tension, seule une très faible partie du courant se propageant dans le milieu conducteur constitué par l'eau de mer est déviée dans le dispositif de mesure de tension, ce qui pose des problèmes de métrologie. De plus, les électromètres à mesure de tension sont généralement encombrants. En effet, pour obtenir un rapport signal sur bruit satisfaisant, la distance l séparant les deux électrodes doit être relativement importante, typiquement de l'ordre de quelques mètres à plusieurs kilomètres.

Pour pallier ces inconvénients, on a proposé un autre type de dispositif de mesure de champ électrique en milieu conducteur, dit "à mesure de courant", qui réalise une détermination de la densité de courant produit, sous l'effet du champ électrique, dans un volume fixé de milieu conducteur.

Un dispositif de ce type est par exemple décrit dans le brevet français N°9102273 de la demanderesse.

D'autres dispositifs de ce type sont décrits dans les documents WO2008/121796, US3641427 et US2012/161774.

Les dispositifs de ce type, que l'on appellera ci-après électromètres à mesure de courant, peuvent être plus compacts que les électromètres à mesure de tension, et peuvent en outre présenter une meilleure sensibilité, ainsi qu'un meilleur rapport signal sur bruit, notamment pour mesurer des champs électriques dans des bandes de fréquence basses, typiquement dans des bandes de fréquences comprises entre 0 et 10 Hz.

La présente demande concerne plus particulièrement le domaine des électromètres à mesure de courant. Il serait en effet souhaitable d'améliorer certains aspects des électromètres à mesure de courant existants.

Résumé

Ainsi, un mode de réalisation prévoit un dispositif de mesure d'un champ électrique en milieu conducteur selon la revendication 1. Selon un mode de réalisation, le procédé de calibration comprend en outre le calcul d'une valeur de champ électrique E à partir de la tension ΔV mesurée à l'étape b) par la formule E=ΔV/L, L étant la distance entre les électrodes, et le calcul d'un coefficient de proportionnalité β entre le champ E et le courant I mesuré à l'étape a).

Selon un mode de réalisation, lors d'une phase de calibration, les étapes a) et b) sont répétées périodiquement une pluralité de fois.

Selon un mode de réalisation, la fréquence de répétition des étapes a) et b) est comprise entre 1 et 1000 Hz.

Selon un mode de réalisation, l'unité de traitement est en outre adaptée, lors d'une phase de mesure de champ électrique, à commander le commutateur pour connecter le dispositif de mesure de courant entre les électrodes, à mesurer le courant I entre les électrodes au moyen du dispositif de mesure de courant, et à déduire du courant I le champ électrique E du milieu conducteur selon un rapport de proportionnalité préalablement déterminé.

Selon un mode de réalisation, le commutateur est un interrupteur au mercure.

Selon un mode de réalisation, le commutateur est un transistor.

Selon un mode de réalisation, le dispositif de mesure de courant comprend une bobine reliant les électrodes et un magnétomètre adapté à mesurer le champ magnétique induit par la circulation d'un courant dans la bobine.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 illustre de façon schématique un exemple d'un électromètre à mesure de courant ; et
la figure 2 illustre de façon schématique un exemple d'un mode de réalisation d'un électromètre à mesure de courant.

Description détaillée

De mêmes éléments ont été désignés par de mêmes références aux différentes figures et, de plus, les diverses figures ne sont pas tracées à l'échelle. Par ailleurs, dans la suite de la description, sauf précision contraire, les expressions "approximativement", "sensiblement", et "de l'ordre de" signifient à 10 % près, de préférence à 5 % près.

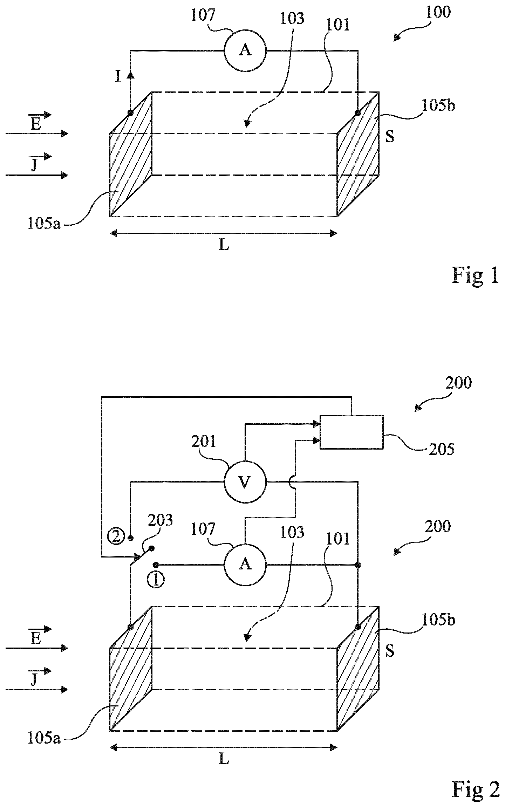

La figure 1 illustre de façon schématique un exemple d'un électromètre à mesure de courant 100 destiné à être placé dans un milieu conducteur dans lequel on souhaite mesurer un champ électrique, par exemple de l'eau de mer. Le dispositif 100 comprend une enceinte 101 hermétiquement close, représentée en traits pointillés sur la figure, délimitant un volume 103 d'un milieu isolant, par exemple de l'air ou du vide. Deux électrodes 105a et 105b sont disposées à l'extérieur de l'enceinte 101, de façon que chaque électrode ait une face en contact avec le milieu conducteur lorsque l'électromètre est immergé. Dans cet exemple, les deux électrodes 105a et 105b sont approximativement planes et parallèles entre elles, ont sensiblement la même surface S, et sont séparées par une distance L. Les électrodes 105a et 105b sont par exemple disposées sur des parois extérieures opposées de l'enceinte. A titre d'exemple, l'enceinte 101 a la forme générale d'une portion de tube à section cylindrique ou rectangulaire, les électrodes étant disposées sur les faces d'extrémités transversales de l'enceinte. Un dispositif de mesure de courant 107 relie les deux électrodes. A titre d'exemple non limitatif, le dispositif de mesure de courant 107 comprend une bobine dans laquelle circule le courant I canalisé par les électrodes 105a et 105b, et un magnétomètre adapté à mesurer le champ magnétique induit par la circulation du courant I dans la bobine. La mesure du champ magnétique induit par la circulation du courant I dans la bobine permet de déterminer la valeur du courant I. A titre de variante, le système de mesure de courant peut comporter un montage comprenant un transformateur et un amplificateur, un ampèremètre, etc.

En fonctionnement, l'électromètre 100 est immergé dans un milieu conducteur, par exemple de l'eau de mer, soumis à un champ électrique E que l'on souhaite mesurer. Sous l'effet du champ électrique E, un courant de densité $\sigma_e * E$ circule dans le milieu conducteur, $\sigma_e$ désignant la conductivité électrique du milieu conducteur. Au niveau de l'électromètre, un courant de densité $J = \alpha * \sigma_e * E$ circule entre les électrodes 105a et 105b, $\alpha$ étant un coefficient fonction du rapport entre la conductivité électrique $\sigma_c$ de l'électromètre et la conductivité électrique $\sigma_e$ de l'eau, avec $\sigma_c = L/(S*Z_c)$, $Z_c$ désignant l'impédance de l'électromètre, avec $Z_c = Z_{elec} + Z_{int}$, $Z_{elec}$ étant l'impédance des électrodes de l'électromètre et $Z_{int}$ étant l'impédance du ou des éléments connectés entre les électrodes, parmi lesquels on trouve au moins le dispositif de mesure de courant 107. En particulier, $\alpha$ est égal à 1 si l'électromètre 100 est tel que sa conductivité électrique $\sigma_c$ est identique à la conductivité $\sigma_e$ du milieu conducteur, c'est-à-dire si l'électromètre 100 est tel que son impédance est égale à celle de la tranche du milieu conducteur à laquelle il se substitue. A titre d'exemple, les inventeurs ont déterminé que pour un électromètre comportant une enceinte isolante en forme de cylindre droit de rayon R et de longueur L dont les électrodes sont disposées sur les deux faces circulaires opposées de l'enceinte, le paramètre $\alpha$ s'exprime comme suit :

$$\alpha = \frac{\sigma_c}{\sigma_e} + \frac{1 - \frac{\sigma_c}{\sigma_e}}{1 + 1{,}24 \frac{\sigma_c}{\sigma_e}\left(\frac{L}{R}\right)^{0{,}90}} .$$

Plus généralement, le paramètre $\alpha$ peut être déterminé par calcul ou de manière empirique quelle que soit la forme de l'électromètre.

Les électrodes 105a et 105b permettent de canaliser la densité de courant J. Le courant canalisé I circulant entre les électrodes 105a et 105b est égal à $I = S*J$. Ce courant I peut être mesuré par le dispositif de mesure de courant 107.

La conductivité $\sigma_e$ du milieu conducteur dans lequel est utilisé l'électromètre 100 est supposée connue, et, connaissant les caractéristiques de l'électromètre, le coefficient $\alpha$ peut être déterminé. Le champ électrique E peut alors se déduire de la mesure du courant I par la formule $E = I/(S*\alpha*\sigma_e)$. L'électromètre peut comporter des moyens de traitement, non représentés, adaptés à déterminer le champ électrique E à partir de la mesure du courant I.

Un inconvénient de l'électromètre 100 est que, en pratique, la conductivité $\sigma_e$ du milieu conducteur peut être inconnue et/ou peut varier entre deux mesures, par exemple lorsque la concentration en sel de l'eau de mer varie lorsque l'électromètre est utilisé en milieu marin. De plus, avec le temps, les électrodes 105a et 105b peuvent s'altérer, ce qui peut entrainer une modification de leur impédance et donc une modification de l'impédance de l'électromètre. Dans ces conditions, le coefficient de proportionnalité $\beta = S*\alpha*\sigma_e$ utilisé par l'électromètre pour déterminer le champ électrique E à partir de la mesure du courant I n'est plus valable, ce qui entraine des erreurs de mesure.

Il serait souhaitable de pouvoir disposer d'un électromètre à mesure de courant pouvant être calibré facilement dans son environnement d'utilisation, pour pouvoir fournir des mesures précises de champ électrique y compris en cas de variation de la conductivité électrique du milieu conducteur à l'étude, ou de l'impédance des électrodes de l'électromètre.

La figure 2 illustre de façon schématique un exemple d'un mode de réalisation d'un électromètre à mesure de courant 200 destiné à être immergé dans un milieu conducteur dans lequel on souhaite mesurer un champ électrique, par exemple de l'eau de mer. L'électromètre 200 de la figure 2 comprend des éléments communs avec l'électromètre 100 de la figure 1. Ces éléments et leur fonctionnement ne seront pas détaillés à nouveau ci-après. Dans la suite, seules les différences entre l'électromètre 200 de la figure 2 et l'électromètre 100 de la figure 1 seront mises en exergue.

Selon un aspect d'un mode de réalisation, on prévoit un électromètre à mesure de courant comportant, en plus du dispositif de mesure de courant 107 adapté à mesurer le courant circulant entre les électrodes 105a et 105b, un dispositif de mesure de tension 201 adapté à mesurer la tension entre les électrodes 105a et 105b.

L'électromètre 200 comprend en outre un commutateur 203 permettant de connecter alternativement le dispositif de mesure de courant 107 et le dispositif de mesure de tension 201 entre les électrodes 105a et 105b. En fonctionnement, seul l'un des deux dispositifs de mesure 107 et 201 est connecté entre les électrodes 105a et 105b à un instant donné. Dans l'exemple représenté, le commutateur 203 est un commutateur à deux positions désignées respectivement par les références 1 et 2. En position 1, le dispositif de mesure de courant 107 est connecté entre les électrodes 105a et 105b et le dispositif de mesure de tension 201 est déconnecté de l'électrode 105a, et, en position 2, le dispositif de mesure de tension 201 est connecté entre les électrodes 105a et 105b et le dispositif de mesure de courant 107 est déconnecté de l'électrode 105a. De préférence, le commutateur 203 est un commutateur présentant une résistance faible à l'état passant. A titre d'exemple, le commutateur 203 est un interrupteur au mercure, ou un transistor.

L'électromètre 200 comprend en outre une unité de traitement et de commande 205 adaptée à lire et traiter des mesures fournies par les dispositifs de mesure 107 et 201, et à commander le commutateur 203.

Lors d'une phase de mesure de champ électrique, le commutateur 203 est maintenu en position 1, c'est-à-dire que le dispositif de mesure de tension 201 est déconnecté. L'électromètre 200 fonctionne alors à la manière d'un électromètre à mesure de courant usuel. L'unité de traitement 205 peut être utilisée pour déterminer le champ électrique E à partir de la mesure du courant I canalisé par les électrodes 105a, 105b. Le coefficient de proportionnalité $\beta = S^* \alpha^* \sigma_e$ utilisé pour déterminer le champ électrique E à partir d'une mesure du courant I peut avoir été déterminé au préalable lors d'une phase de calibration de l'électromètre.

Selon un aspect d'un mode de réalisation, on prévoit un procédé de calibration de l'électromètre 200 dans lequel on réalise une ou plusieurs mesures de tension au moyen du dispositif 201, afin de calibrer le système de mesure en courant et notamment de déterminer le coefficient de proportionnalité $\beta$ permettant de déterminer le champ électrique E à partir d'une mesure du courant I réalisée par le dispositif 107 lorsque le commutateur est en position 1.

A titre d'exemple, lors d'une phase de calibration de l'électromètre 200, les étapes suivantes sont mises en oeuvre par l'unité de traitement et de commande 205.

Lors d'une première étape, le commutateur 203 est commandé en position 1, et une mesure du courant I canalisé par les électrodes 105a, 105b est réalisée au moyen du dispositif de mesure 107.

Lors d'une deuxième étape, le commutateur 205 est commandé en position 2, et une valeur de champ électrique E est déterminée par une mesure en tension au moyen du dispositif de mesure de tension 201. Lors de cette étape, le champ E est déduit de la tension $\Delta V$ mesurée par le dispositif 201 entre les électrodes 105a et 105b par la formule $E = \Delta V / L$.

Afin de maximiser le rapport signal sur bruit, ces deux étapes peuvent être répétées périodiquement pendant un certain temps, par exemple pendant une période comprise entre 1 min et 1 h, à une fréquence suffisante pour mesurer les signaux I et E aux fréquences souhaitées, c'est-à-dire à une fréquence au moins deux fois supérieure à la plus haute fréquence à laquelle on souhaite mesurer le champ E, par exemple à une fréquence comprise entre 1 et 1000 Hz.

La valeur du coefficient $\beta$ est ensuite déterminée en calculant le rapport entre les signaux I et E mesurés respectivement au moyen du dispositif de mesure de courant 107 et au moyen du dispositif de mesure de tension 201.

Une fois le coefficient $\beta$ déterminé, le commutateur 203 peut être replacé en position 1. La calibration de l'électromètre est alors terminée, et des mesures de champ électrique peuvent être réalisées au moyen du seul dispositif de mesure de courant 107, en utilisant le nouveau coefficient $\beta$ pour déterminer le champ E à partir d'une mesure du courant I par le dispositif 107.

Le procédé de calibration peut être répété aussi souvent que nécessaire pour éviter que la dérive éventuelle des paramètres d'impédance des électrodes 105a, 105b et de conductivité $\sigma_e$ n'entraine une dégradation significative de la précision de l'électromètre.

Un avantage des modes de réalisation décrits est que la calibration peut être réalisée in-situ, c'est-à-dire sans avoir à extraire l'électromètre du milieu étudié, et sans avoir à réaliser des mesures complexes de la conductivité électrique $\sigma_e$ du milieu étudié et de la conductivité électrique $\sigma_c$ de l'électromètre.

Des modes de réalisation particuliers ont été décrits. Diverses variantes et modifications apparaîtront à l'homme de l'art.

En particulier, l'homme du métier saura mettre en oeuvre le fonctionnement recherché en utilisant d'autres dispositions du commutateur 203 que celle représentée en figure 2.

De plus, les modes de réalisation décrits peuvent être adaptés à des électromètres à mesure de courant comportant plusieurs paires d'électrodes orientées dans des directions différentes et permettant de réaliser des mesures de champ électrique dans plusieurs directions de l'espace.

## Revendications

1. Dispositif (200) de mesure d'un champ électrique en milieu conducteur, comprenant :

deux électrodes (105a, 105b) séparées par un volume (103) d'un milieu isolant ;
un dispositif de mesure de courant (107) ; **caractérisé en ce que** le dispositif comprend:

un dispositif de mesure de tension (201) ;
un commutateur (203) permettant de connecter alternativement le dispositif de mesure de courant (107) et le dispositif de mesure de tension (201) entre les électrodes (105a, 105b) ; et
une unité de commande et de traitement (205) adaptée à mettre en oeuvre un procédé de calibration comportant les étapes suivantes :

a) commander le commutateur (203) pour connecter le dispositif de mesure de courant (107) entre les électrodes (105a, 105b), et mesurer le courant I entre les électrodes au moyen du dispositif de mesure de courant (107) ; et
b) commander le commutateur (203) pour connecter le dispositif de mesure de tension (201) entre les électrodes (105a, 105b), et mesurer la tension ΔV entre les électrodes au moyen du dispositif de mesure de tension (201).

2. Dispositif (200) selon la revendication 1, dans lequel le procédé de calibration comprend en outre le calcul d'une valeur de champ électrique E à partir de la tension ΔV mesurée à l'étape b) par la formule E=ΔV/L, L étant la distance entre les électrodes (105a, 105b), et le calcul d'un coefficient de proportionnalité β entre le champ E et le courant I mesuré à l'étape a).

3. Dispositif (200) selon la revendication 1 ou 2, dans lequel, lors d'une phase de calibration, les étapes a) et b) sont répétées périodiquement une pluralité de fois.

4. Dispositif (200) selon la revendication 3, dans lequel la fréquence de répétition des étapes a) et b) est comprise entre 1 et 1000 Hz.

5. Dispositif (200) selon l'une quelconque des revendications 1 à 4, dans lequel l'unité de traitement (205) est en outre adaptée, lors d'une phase de mesure de champ électrique, à commander le commutateur (203) pour connecter le dispositif de mesure de courant (107) entre les électrodes (105a, 105b), à mesurer le courant I entre les électrodes au moyen du dispositif de mesure de courant (107), et à déduire du courant I le champ électrique E du milieu conducteur selon un rapport de proportionnalité préalablement déterminé.

6. Dispositif (200) selon l'une quelconque des revendications 1 à 5, dans lequel le commutateur (203) est un interrupteur au mercure.

7. Dispositif (200) selon l'une quelconque des revendications 1 à 5, dans lequel le commutateur (203) est un transistor.

8. Dispositif (200) selon l'une quelconque des revendications 1 à 7, dans lequel le dispositif de mesure de courant (107) comprend une bobine reliant les électrodes (105a, 105b) et un magnétomètre adapté à mesurer le champ magnétique induit par la circulation d'un courant (I) dans la bobine.

**Patentansprüche**

1. Eine Einrichtung (200) zum Messen eines elektrischen Feldes in einem leitfähigen Medium, das folgendes aufweist:

zwei Elektroden (105a, 105b), die durch ein Volumen (103) eines isolierenden Mediums getrennt sind;
eine Strommesseinrichtung (107);
**dadurch gekennzeichnet, dass** die Einrichtung folgendes aufweist:

eine Spannungsmesseinrichtung (201);
einen Schalter (203), zum Ermöglichen von abwechselnden Verbinden der Strommesseinrichtung (107) und der Spannungsmesseinrichtung (201) zwischen den Elektroden (105a,105b); und
eine Steuer- und Verarbeitungseinheit (205), die zum Implementieren eines Kalibrierungsverfahrens fähig ist, das die folgenden Schritte aufweist:

a) Steuern des Schalters (203) zum Verbinden der Strommesseinrichtung (107) zwischen den Elektroden (105a,105b) und Messen von Strom I zwischen den Elektroden mit der Strommesseinrichtung (107); und
b) Steuern des Schalters (203) zum Verbinden der Spannungsmesseinrichtung (201) zwischen den Elektroden (105a,105b), und Messen von Spannung ΔV zwischen den Elektroden mit der Spannungsmesseinrichtung (201).

2. Einrichtung (200) nach Anspruch 1, wobei das Kalibrierungsverfahren ferner Berechnen eines elektrischen Feldwerts E aus Spannung ΔV, die im Schritt b) gemessen wurde, durch Formel E = ΔV/L, wobei L der Abstand zwischen Elektroden (105a,105b) ist, und Berechnen eines proportionalen Koeffizienten β zwischen Feld E und Strom I, der in Schritt a) gemessen wurde, aufweist.

3. Einrichtung (200) nach Anspruch 1 oder 2, wobei, während einer Kalibrierungsphase, Schritte a) und b) periodisch mehrere Male wiederholt werden.

4. Einrichtung (200) nach Anspruch 3, wobei die Frequenz, mit der Schritte a) und b) wiederholt werden, in dem Bereich von 1 bis 1000 Hz liegt.

5. Einrichtung (200) nach einem der Ansprüche 1 - 4, wobei die Verarbeitungseinheit (205) ferner fähig ist, während einer elektrischen Feldmessphase den Schalter (203) zum Verbinden der Strommesseinrichtung (107) zwischen den Elektroden (105a,105b) zu steuern, und zwar zum Messen des Strom I zwischen den Elektroden mit der Strommesseinrichtung (107) und zum Ableiten, aus dem Strom I, des elektrischen Felds E des leitfähigen Mediums entsprechend einem vorher bestimmten proportionalen Verhältnisses.

6. Einrichtung (200) nach einem der Ansprüche 1 - 5, wobei der Schalter (203) ein Quecksilberschalter ist.

7. Einrichtung (200) nach einem der Ansprüche 1 - 5, wobei der Schalter (203) ein Transistor ist.

8. Einrichtung (200) nach einem der Ansprüche 1 - 7, wobei das Strommessgerät (107) eine Spule, welche die Elektroden (105a,105b) verbindet, und ein Magnetometer aufweist, das in der Lage ist, das magnetische Feld zu messen, das durch einen fließenden Strom I durch die Spule induziert wird.

## Claims

1. A device (200) for measuring an electric field in a conducting medium, comprising:

    two electrodes (105a, 105b) separated by a volume (103) of an insulating medium;
    a current measurement device (107);
    **characterized in that** the device comprises:

        a voltage measurement device (201);
        a switch (203) enabling to alternately connect the current measurement device (107) and the voltage measurement device (201) between the electrodes (105a, 105b); and
        a control and processing unit (205) capable of implementing a calibration method comprising the steps of:

    a) controlling the switch (203) to connect the current measurement device (107) between the electrodes (105a, 105b), and measuring current I between the electrodes by means of the current measurement device (107); and
    b) controlling the switch (203) to connect the voltage measurement device (201) between the electrodes (105a, 105b), and measuring voltage ΔV between the electrodes by means of the voltage measurement device (201).

2. The device (200) of claim 1, wherein the calibration method further comprises calculating an electric field value E from voltage ΔV measured at step b) by formula E=ΔV/L, L being the distance between electrodes (105a, 105b), and calculating a proportionality coefficient β between field E and current I measured at step a).

3. The device (200) of claim 1 or 2, wherein, during a calibration phase, steps a) and b) are periodically repeated a plurality of times.

4. The device (200) of claim 3, wherein the frequency at which steps a) and b) are repeated is in the range from 1 to 1,000 Hz.

5. The device (200) of any of claims 1 to 4, wherein the processing unit (205) is further capable, during an electric field measurement phase, of controlling the switch (203) to connect the current measurement device (107) between the electrodes (105a, 105b), of measuring current I between the electrodes by means of the current measurement device (107), and of deducing from current I the electric field E of the conducting medium according to a previously-determined proportionality ratio.

6. The device (200) of any of claims 1 to 5, wherein the switch (203) is a mercury switch.

7. The device (200) of any of claims 1 to 5, wherein the switch (203) is a transistor.

8. The device (200) of any of claims 1 to 7, wherein the current measurement device (107) comprises a coil connecting the electrodes (105a, 105b) and a magnetometer capable of measuring the magnetic field induced by the flowing of a current (I) through the coil.

Fig 1

Fig 2

**EP 3 067 704 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 9102273
- WO 2008121796 A
- US 3641427 A
- US 2012161774 A